Europäisches Patentamt

European Patent Office

Office européen des brevets

(11) Publication number: **0 298 219 A2**

## EUROPEAN PATENT APPLICATION

(21) Application number: 88107315.9

(51) Int. Cl.⁴: **G01R 1/073**

(22) Date of filing: 06.05.88

(30) Priority: 08.06.87 US 59662

(43) Date of publication of application:
**11.01.89 Bulletin 89/02**

(84) Designated Contracting States:
**DE FR GB**

(71) Applicant: TEKTRONIX, INC.
Howard Vollum Park 14150 S.W. Karl Braun
Drive P.O. Box 500
Beaverton Oregon 97077(US)

(72) Inventor: **Janko, Bozidar**
2180 S.W. Sunset Drive
Portland Oregan 97201(US)

(74) Representative: **Strasse, Joachim, Dipl.-Ing. et al**
Strasse und Stoffregen European Patent
Attorneys Zweibrückenstrasse 17
D-8000 München 2(DE)

(54) **Method and apparatus for testing unpackaged integrated circuits in a hybrid circuit environment.**

(57) An apparatus for use in testing an integrated circuit in its intended operating environment within a hybrid circuit includes a hybrid circuit of the type within which the integrated circuit is to operate when subsequently mounted thereon. An aperture is formed in a hybrid substrate of the hybrid circuit in a location where the integrated circuit would otherwise be mounted, and a dielectric membrane is clamped over the aperture. Conductive bumps in the underside of the periphery of the membrane engage conductors on the upper surface of the hybrid substrate surrounding the aperture which conductors would normally connect to terminals of the integrated circuit. Conductive bumps on the under side of a central area of the membrane engage contact areas on the contact face of an integrated circuit under test situated therebelow and a plurality of conductor runs supported by the membrane extend from the conductive bumps in the central area of the membrane to the conductive bumps in the periphery of the membrane, thereby electrically interconnecting the integrated circuit under test to the hybrid circuit.

# METHOD AND APPARATUS FOR TESTING UNPACKAGED INTEGRATED CIRCUITS IN A HYBRID CIRCUIT ENVIRONMENT

This invention relates to multiple lead probes for integrated circuits, and in particular to a method and apparatus for testing an unpackaged integrated circuit for its ability to operate within a hybrid circuit when subsequently mounted thereon.

## Background of the Invention

An important aspect of the manufacture of hybrid integrated circuits is the testing of integrated circuits therein in order to verify that they operate according to specifications. Although integrated circuits could be tested after they have been mounted on a hybrid circuit, the expense involved in dicing a wafer and mounting the individual integrated circuits thereof makes it desirable to test integrated circuits as early as possible in the fabrication process so that unnecessary efforts will not be expended on faulty devices. It is therefore desirable that these circuits be tested either immediately after wafer fabrication is completed, and before dicing, or after dicing but before mounting on a hybrid. In either case, it is necessary to make electrical connections to the circuit's external connections (usually bonding pads) in a nondestructive way, so as not to interfere with subsequent connection operations.

It is desirable that an integrated circuit be tested under its design operating conditions and to the extremes of its design performance range. In particular, for high frequency circuits designed to operate within hybrid circuits having input and output signal bandwidths approaching and exceeding 1 GHz, it is necessary that operation of such integrated circuits be evaluated at these high frequencies. At such high frequencies, capacitances and inductances of the test apparatus can significantly influence the operation of the circuit under test. It is therefore desirable that in testing a high frequency integrated circuit the electrical characteristics of the test environment be as close as possible to those of the anticipated operating environment of the integrated circuit after it has been diced and mounted in a hybrid circuit.

U. S. patent application Serial No. 812,145, filed December 23, 1985, the disclosure of which is hereby incorporated by reference, discloses a probe assembly for use in testing an integrated circuit. The probe assembly comprises a stiff support member formed with an aperture, and an elastically-deformable membrane. Both the support member and the membrane comprise dielectric material and portions of conductive material supported by the dielectric material in electrically-insulated relationship. The portions of conductive material of the membrane constitute inner contact elements distributed over a first main face of the membrane in a first pattern corresponding to the pattern of contact areas on the contact face of the integrated circuit, outer contact elements distributed about a peripheral area of the membrane in a second pattern, and transmission lines extending from the inner contact elements to the outer contact elements respectively.

The portions of conductive material of the support member comprise inner contact elements that are distributed about the aperture in a pattern corresponding generally to the second pattern, and transmission lines extending from the inner contact elements of the support member to connectors accessible to cables from testing apparatus. The membrane is secured to the support member so that it extends over the aperture, such that the outer contact elements of the membrane are electrically connected to respective inner contact elements of the support member.

In a practical form of the probe assembly the support member is disposed horizontally in use, and the inner contact elements of the support member are exposed at the upper surface thereof. The outer contact elements of the membrane are exposed at the first main face of the membrane, and the membrane is clamped at its peripheral area to the upper surface of the support member using a body of elastomer material that spans the aperture in the support member. The first main face of the membrane is presented downwards, towards the interior of the aperture in the support member, and the integrated circuit is placed on a pedestal that is sufficiently small to enter the aperture in the support member.

The body of elastomer material has a downwardly-projecting protuberance that engages the membrane directly above the inner contact elements, so that when the pedestal is raised and the contact areas of the integrated circuit engage the inner contact elements of the membrane, upward deformation of the membrane is resisted in a resiliently yieldable fashion and the body of elastomer material supplies contact force for achieving pressure contact between the contact areas of the integrated circuit and the inner contact elements of the membrane. The maximum linear dimension of the aperture in the support member is smaller than the diameter of a standard semiconductor wafer. Because the integrated circuit under test must be lifted into the aperture in the support member, the probe assembly is not well suited for testing integrated circuits in wafer form.

In co-pending U. S. patent application No. - (attorney docket number DF 4244) entitled, "Multiple Lead Probe for Integrated Circuits in Wafer Form", filed , by Hans J. Greub and Valdis E. Garuts, a probe suitable for use in testing an integrated circuit in wafer form comprises a stiff support member formed with an aperture, and an elastically-deformable membrane. The membrane has first and second main faces, the periphery of the first main face being clamped to an upper surface of the support member surrounding the aperture. Both the support member and the membrane comprise dielectric material and portions of conductive material supported by the dielectric material in electrically-insulated relationship. Portions of conductive material of the membrane constitute inner contact elements exposed at the first main face in the central area of the membrane in a first pattern corresponding to the pattern of contact areas on the contact face of the integrated circuit. Other portions of the conductive material of the membrane constitute outer contact elements distributed in a second pattern about the peripheral area of first main face of the membrane and transmission lines extending from the inner contact elements to the outer contact elements respectively.

Portions of conductive material of the support member comprise contact elements exposed on the upper surface of the support member and distributed about the aperture in a pattern corresponding generally to the second pattern, and transmission lines extending from the inner contact elements of the support member to testing apparatus. The outer contact elements of the membrane include contact bumps of conductive material which project out of the first main face so as to engage and electrically connect respective contact elements of the support member. A removable pressure plate clamps the peripheral area of the membrane between a resilient pad and the support member to hold the membrane in place on the support member and to ensure good electrical contact between the bumps on the outer contact elements of the membrane and the contact elements of the support member.

The inner contact elements of the membrane each include a contact bump of conductive material projecting downwards from the first main face of the membrane. The central area of the first main face of the membrane extends downward through the aperture such that the inner contact elements of the membrane extend below the under surface of the support member whereby the inner contact bumps may engage contact areas on an integrated circuit in a wafer situated below the under surface of the support member. A shaft mounted between the pressure plate and the central area of the second main face of the membrane has elastomeric ends which resist upward movement of the inner contact bumps in a resiliently yielding fashion. Inasmuch as the inner contact bumps extend below the lower surface of the support member, the integrated circuit need not be raised into the aperture thereof, and the probe assembly is therefore suitable for accessing contact areas on an integrated circuit on a wafer which may be larger than the aperture.

While the previously described probes of the prior art minimize influence on the integrated circuit being tested by the probes themselves, the probes do not reproduce the environment in which the integrated circuit is to operate when diced and mounted in a hybrid circuit in close proximity to other electronic devices. In some applications, capacitances between conductors on the integrated circuit and other conductors of the hybrid circuit, inductances of conductors connected to the integrated circuit, impedance of the bondwires of the integrated circuit, and high frequency signals radiated by other devices mounted on the hybrid circuit may strongly influence the operating characteristics of the integrated circuit under test.

### Summary of the Invention

A hybrid circuit typically includes a hybrid substrate of stiff dielectric material and a set of integrated circuits and other electronic devices mounted on the hybrid substrate and interconnected by conductors deposited on the surface of the hybrid substrate. In accordance with the invention, an apparatus for testing operation of one of the integrated circuits prior to mounting is fashioned from a hybrid circuit similar to the hybrid circuit within which the integrated circuit is to be mounted. The apparatus permits testing of the integrated circuit prior to mounting on a hybrid circuit, with tests being performed within a test environment closely resembling the intended application hybrid circuit environment of the integrated circuit.

An aperture is formed in the hybrid substrate of the hybrid circuit in an area where the integrated circuit would otherwise be mounted. The aperture is positioned such that conductors on the upper surface of the hybrid substrate, which normally lead to bond wires accessing the integrated circuit, terminate at the edges of the aperture. Any insulating coating on the conductors in an area of the hybrid substrate surrounding the aperture is removed so that upper surfaces of the conductors within such area are exposed.

An elastically-deformable membrane, having upper and lower main faces, is mounted on the hybrid substrate with a peripheral area of the lower main face abutting the area on the upper surface of the hybrid substrate surrounding the aperture, the area containing the exposed conductors. The membrane comprises dielectric material and portions of conductive material supported by the dielectric material in electrically-insulated relationship. Portions of the conductive material of the membrane constitute outer contact elements distributed in a pattern about the peripheral area of the lower main face, which pattern matches the pattern of the exposed surfaces of the conductors in the area of the hybrid substrate surrounding the aperture. The outer contact elements include contact bumps of conductive material which project out of the lower main face of the membrane so as to engage the exposed surfaces of the conductors on the hybrid substrate therebelow. A removable pressure plate clamps the peripheral area of the membrane between a resilient body and the upper surface of the hybrid substrate so as to firmly hold the peri pheral area of the membrane in place on the hybrid substrate and to ensure good electrical contact between the bumps on the outer contact elements of the membrane and the conductors of the hybrid substrate.

Additional portions of the conductive material of the membrane comprise inner contact elements exposed at the lower main face in the central area of the membrane in a first pattern corresponding to the pattern of contact areas on the contact face of the integrated circuit. Each inner contact element also includes a contact bump of conductive material projecting downward from the central area of lower main face of the membrane. The resilient body interposed between the pressure plate and the membrane applies pressure on the central area of the membrane such that the contact bumps on the inner contact elements therein firmly engage contact areas on an integrated circuit in a wafer situated therebelow. Metallic columns extending through the membrane and conductors deposited on the upper main face of the membrane electrically interconnect inner contact elements with corresponding outer contact elements of the membrane.

Except for the integrated circuit under test, all other integrated circuits and electronic devices are mounted on the hybrid substrate in a normal fashion. The inner and outer contact elements and the interconnecting conductors and metallic columns of the membrane electrically connect contact pads on the integrated circuit under test to conductors on the hybrid substrate such that when appropriate externally generated signals and power supplies are applied to external terminals of the hybrid circuit, the integrated circuit under test may operate substantially as if it were mounted in an operating hybrid circuit. The apparatus of the present invention is particularly suited for screening high frequency integrated circuits prior to mounting in a hybrid circuit to ensure that they operate correctly in their intended operating environment when integrated circuit performance is significantly influenced by operating environment.

It is accordingly an object of the invention to provide a method and apparatus for testing an integrated circuit to ensure that it will operate properly when subsequently mounted in a hybrid circuit, wherein the operating environment during the test is substantially similar to the operating environment of the hybrid circuit.

The subject matter of the present invention is particularly pointed out and distinctly claimed in the concluding portion of this specification. However, both the organization and method of operation of the invention, together with further advantages and objects thereof, may best be understood by reference to the following description taken in connection with accompanying drawings wherein like reference characters refer to like elements.

## Drawings

FIG. 1 is a sectional view of an apparatus for testing the operation of an integrated circuit in accordance with the present invention;

FIG. 2 is a plan view of lower surface the membrane of FIG. 1;

FIG. 3 is a sectional view of the membrane of FIG. 2;

FIG. 4 is an enlarged sectional view of an alternative embodiment of the present invention;

FIG. 5 is a plan view of the lower surface of the membrane of FIG. 4 with the membrane removed from the probe; and

FIG. 6 is a sectional view of the membrane of FIG. 5.

## Detailed Description

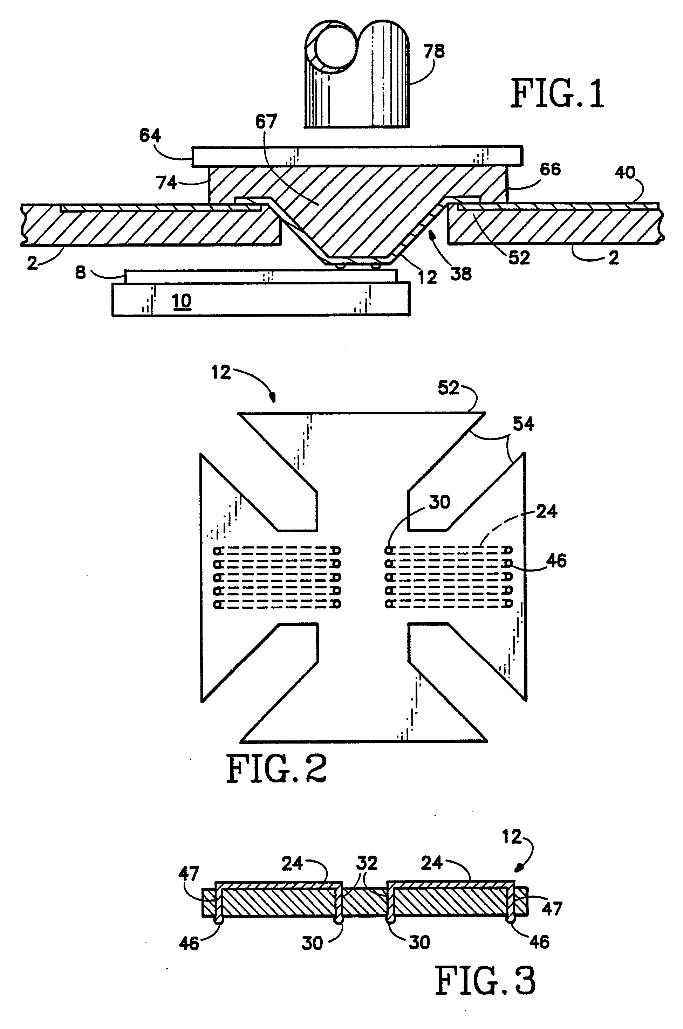

A preferred embodiment of the apparatus of the present invention, shown in FIGS. 1-3, is adapted to electrically interconnect contact pads on an integrated circuit in a wafer 8 to conductors on a hybrid substrate so as to enable the integrated circuit to operate as if the integrated circuit were diced and mounted on the hybrid substrate and electrically interconnected with other integrated circuits and devices mounted on the hybrid substrate.

The wafer 8, including the integrated circuit that is to be tested, is mounted on a wafer support 10. The integrated circuit has contact pads (not shown) distributed over its upper face, referred to herein as the contact face of the integrated circuit.

The apparatus comprises the hybrid substrate 2 itself in which an aperture 38 has been formed in an area where the integrated circuit would otherwise be mounted. The aperture 38, suitably rectangular in shape, is positioned such that strip line conductors 40 on the upper surface of the hybrid substrate, which normally lead to bond wires accessing the integrated circuit, terminate at the edges of the aperture. Any insulating coating on the conductors in an interior area of the hybrid substrate surrounding the aperture is removed so that portions of the upper surfaces of the conductors within such area are exposed.

An elastically deformable membrane 12 is mounted over aperture 38. As seen in FIGS. 1-3, membrane 12 comprises a single layer of transparent, flexible dielectric material such as polyimide upon an upper surface of which a pattern of conductors 24 has been deposited. A set of inner contact bumps 30 extending below the lower surface of membrane 12 are connected to inner ends of conductors 24 by metallic columns 32 passing through apertures in membrane 12. The apertures in membrane 12 are formed by conventional masking and etching techniques, and the metal of columns 32 and contact bumps 30 is plated into the apertures. Different metals may be used for the columns 32 and the contact bumps 30, e.g., gold for the columns and nickel for the contact bumps, by using two different plating baths. Contact bumps 30 are arranged in a pattern which matches the pattern of contact pads on the contact face of the integrated circuit on wafer 8. A generally similar set of outer contact bumps 46, extending below peripheral areas of the lower surface of membrane 12, are connected to outer ends of conductors 24 by metallic columns 47 also passing through apertures in membrane 12. Contact bumps 46 are arranged in a pattern which matches the pattern of exposed conductors 40 on the surface of hybrid substrate 2 surrounding aperture 38. In FIGS. 2 and 3, the sizes of contact bumps 30 and 46 and conductors in relation to membrane 12 are exaggerated so that they may be seen more clearly. In a practical embodiment of the invention the contact bumps and conductors may be much smaller, and many more contact bumps 30 and 46 may be included on the membrane 12.

Contact bumps 46 are arranged such that when membrane 12 is mounted across aperture 38 of hybrid substrate 2, contact bumps 46 engage corresponding signal conductors 40 on the upper surface of hybrid substrate 2. When not installed on hybrid substrate 2, membrane 12 is substantially flat and cross-shaped, having four legs 52 as seen in FIG. 2. However, when membrane 12 is mounted on hybrid substrate 2 adjacent edges 54 of legs 52 of membrane 12 overlap and membrane 12 becomes bowl-shaped. Thus bumps 30 extend below the under surface of hybrid substrate 2 while the under side of the periphery of membrane 12 abuts the upper side of hybrid substrate 2 near the periphery of aperture 38.

A rigid, transparent pressure plate 64 supplies pressure to a body 66 of resilient, transparent insulating material, such as elastomer, mounted above membrane 12. A central shaft portion 67 of body 66 extends through aperture 38 and distributes pressure on contact bumps 30 so as to limit upward movement of the contact bumps 30 in resiliently yieldable fashion. Pressure plate 64 also applies pressure to an annulus portion 74 of body 66 covering the periphery of membrane 12. This pressure is distributed on contact bumps 46 of membrane 12 so as to ensure good electrical contact between bumps 46 of membrane 12 and the corresponding signal conductors 40 of hybrid substrate 2.

A microscope 78 is used in conjunction with a mechanism (not shown) for controlling the position of wafer support 10 so that the contact bumps 30 may be positioned directly over the appropriate contact pads of a selected integrated circuit of the wafer 8. The positioning mechanism is then used to bring about relative vertical movement between the test apparatus and the wafer support 10 so as to establish pressure contact between the contact bumps 30 and the appropriate connection pads. The flexibility of membrane 12 and the elasticity of body 66 ensure that the pressure contact will not damage the wafer, and also compensate for minor variations in the vertical positions of the connection pads or the contact surfaces of the bumps 30. When a first integrated circuit of wafer 8 has been tested, the positioning mechanism may automatically move the wafer support to bring the next integrated circuit to be tested beneath the contact bumps, and the next integrated circuit may then tested.

The illustrated test apparatus provides an advantage over known test assemblies in that it permits the integrated circuit to be tested within its intended operating environment, a functioning hybrid circuit, before the integrated circuit is mounted thereon. Membrane 12 is inexpensive, can be manufactured using conventional techniques, and may be easily replaced when an integrated circuit having a different contact pattern is to be tested. In addition, the membrane is not easily damaged by contact with the integrated circuit under test and such contact does not damage the integrated circuit.

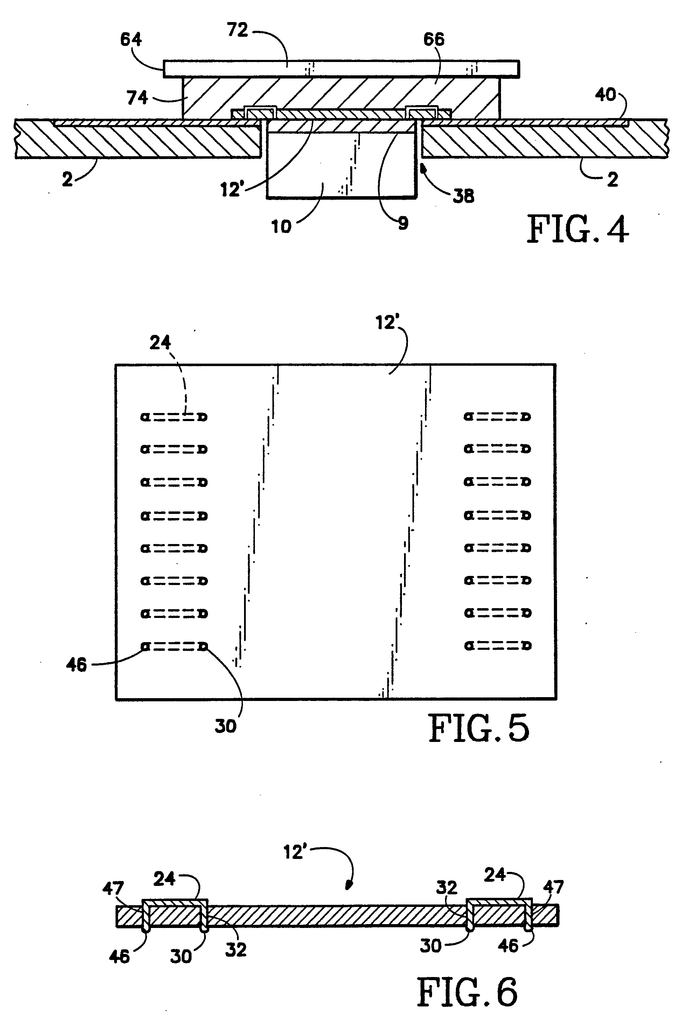

FIGS. 4-6 show an alternative embodiment of the present invention wherein elements similar to the elements of the preferred embodiment of FIGS 1-3 are referenced by similar reference numerals.

The alternative embodiment of the invention may be employed in testing an integrated circuit 9 which has been separated from other integrated circuits of the same wafer. In the alternative embodiment, as in the preferred embodiment, an aperture 38 is formed in hybrid substrate 2 in the location where the integrated circuit would otherwise have been mounted and the upper surfaces of conductors 40 on the top of hybrid substrate 2 which would otherwise connect to the bond wires accessing the circuit are exposed near the edges of the aperture. A membrane 12' is mounted over aperture 38. However, in the alternative embodiment, membrane 12' is rectangular rather than cross-shaped (as shown in FIG. 5) and its central portion does not extend through aperture 38. With reference to FIGS. 5 and 6, membrane 12' also includes a single layer of transparent, flexible dielectric material such as polyimide upon an upper layer of which a pattern of conductors 24 has been deposited, a set of inner contact bumps 30 extending below the lower surface of membrane 12 for contacting contact pads on the integrated circuit 9 and a set of contact bumps 46 for contacting exposed conductors 40 on the surface of hybrid substrate 2 surrounding aperture 38. The bumps 30 are connected to inner ends of conductors 24 by metallic columns 32 passing through apertures in membrane 12 and contact bumps 46 are connected to outer ends of conductors 24 by metallic columns 47 also passing through apertures in membrane 12.

The alternative embodiment also includes an elastomeric body 66 mounted above membrane 12' and a pressure plate 64 mounted above the elastomeric body, but elastomeric body 66 does not include a central shaft portion extending through aperture 38. Instead the integrated circuit 9 is mounted on a chuck 10 which lifts integrated circuit 9 through aperture 38 so that contact pads on the integrated circuit engage contact bumps on the under side of membrane 12'. The elastomeric body 66 limits upward movement of contact pads on integrated circuit 9 in resiliently yielding fashion. An outer portion 74 of elastomeric body 66 also supplies pressure on the periphery of membrane 12' so that contact bumps 46 firmly engage corresponding conductors 40 on the surface of hybrid substrate 2 therebelow. Thus, as in the preferred embodiment, contact bumps 30 and 46, columns 32 and 47, and conductors 24 of the alternative embodiment electrically interconnect conductors 40 to contact pads of the contact face of the integrated circuit under test so that the integrated circuit may be tested for operation within the test environment provided by the hybrid circuit.

The alternative embodiment of the invention has a disadvantage over the preferred embodiment in that integrated circuits cannot be tested until they have been diced because a typical wafer is too large to fit in aperture 38. However, it does have an advantage in that contact bumps 30 and 46, and their interconnecting columns 32 and 47 and conductors 24 more closely simulate the physical arrangement and electrical characteristics of bondwires which connect conductors 40 on the hybrid substrate 2 to bonding pads on the integrated circuit 9 when the integrated circuit is subsequently mounted in a hybrid circuit. In some applications the impedance of the bondwires can strongly influence the behavior of the integrated circuit under test. In such applications the alternative embodiment provides a testing environment more closely resembling the intended application environment than does the preferred embodiment in which the conductors 24 are substantially longer than conductors 24 of the alternative embodiment. In addition, in the alternative embodiment the unpackaged integrated circuit under test is situated closer to its intended mounting position within the hybrid circuit when subsequently mounted thereon which also enables the alternative embodiment to more closely approximate the intended operating environment of the integrated circuit.

While preferred and alternative embodiments of the present invention have been shown and described, it will be apparent to those skilled in the art that many changes and modifications may be made without departing from the invention in its broader aspects. The appended claims are therefore intended to cover all such changes and modifications as fall within the true spirit and scope of the invention.

## Claims

1. Apparatus for testing an integrated circuit within a test environment substantially resembling the operating environment of a first hybrid circuit wherein the integrated circuit is to be mounted and interconnected with other electronic devices on a first hybrid substrate, the apparatus comprising:

a second hybrid circuit substantially similar to said first hybrid circuit comprising electronic devices similar to said other electronic devices and comprising a second hybrid substrate similar to said first hybrid substrate but wherein an aperture is formed in a portion of said second hybrid substrate corresponding to a portion of said first hybrid substrate wherein said integrated circuit is to be mounted, said second hybrid substrate having upper and lower surfaces and conductors formed on said upper surface in an area surrounding said aperture; and

a membrane having first and second opposite main faces, having a plurality of first contact elements distributed about a peripheral area of said first main face in a first pattern corresponding to a pattern in which said first conductors are distributed in said area surrounding said aperture, having a plurality of second contact elements distributed over an interior area of said first main face in a second pattern that corresponds to a pattern in which contact areas are distributed over a face of said integrated circuit, and having conductive signal paths extending from said first contact elements to said second contact elements, said membrane being positioned on said second hybrid substrate such that the peripheral area of said first main face of said membrane contacts said interior area of the upper surface of said second hybrid substrate, and such that said first contact elements of said membrane are in electrically-conductive contact with respective ones of said conductors.

2. The apparatus according to claim 1 wherein the interior area of said membrane extends through said aperture such that the second contact elements of the membrane are held below the lower surface of said second hybrid substrate.

3. The apparatus according to claim 1 further comprising means for securing said membrane to said second hybrid substrate.

4. An apparatus according to claim 3 wherein said means for securing said membrane to said second hybrid substrate comprises:

a body of resilient dielectric material covering said peripheral area of said membrane such that said peripheral area is situated between said body and said interior area of said second hybrid substrate, and

means for applying a distributed downward force to said body and an opposing upward force on said second hybrid substrate such that the peripheral area of said membrane is clamped under pressure between said body and the interior area of said second hybrid substrate.

5. A method for testing an integrated circuit within a test environment closely resembling its intended operating environment in a first hybrid circuit when subsequently mounted on a first hybrid substrate of the type having an upper surface and a lower surface wherein contact areas on the integrated circuit are electrically connected to conductors formed on the upper surface of said hybrid substrate, the method comprising the steps of:

forming an aperture in a second hybrid substrate similar to said first hybrid substrate, said second hybrid substrate being included in a hybrid circuit similar to said first hybrid circuit, the aperture being positioned such that portions of said conductors on the upper surface of said second hybrid substrate are within an interior area of said second hybrid substrate proximate to edges of the aperture; and

mounting on said second hybrid substrate a membrane having first and second opposite main faces, having a plurality of first contact elements distributed about a peripheral area of said first main face in a first pattern that corresponds to a pattern of portions of said conductors in said interior area of the upper surface of said second hybrid substrate, having a plurality of second contact elements distributed over an interior area of said first main face in a second pattern that corresponds to a pattern in which contact areas are distributed over a face of said integrated circuit, and having signal paths extending from said first contact elements to said second contact elements, said membrane being positioned on said second hybrid substrate such that the peripheral area of said first main face of said membrane overlies said interior area of the upper surface of said second hybrid substrate, and such that said first contact elements of said membrane are in electrically-conductive contact with respective conductors on the upper surface of said second hybrid substrate in said interior area of said second hybrid substrate.

6. The method according to claim 5 further comprising the step of extending the interior area of said membrane through said aperture such that the second contact elements of the membrane are held below the lower surface of said second hybrid substrate.

FIG.1

FIG.2

FIG.3

FIG.4

FIG.5

FIG.6